# FASCICULE DE BREVET EUROPEEN

(11) **EP 1 427 107 B1**
(45) Date de publication et mention de la délivrance du brevet: **14.09.2011**
(21) Numéro de dépôt: 03300242.9
(22) Date de dépôt: 02.12.2003
(51) Int. Cl.: H03K 17/722, H01L 29/74

(54) **Commutateur de type SCR commande en HF**
HF-gesteuerter Schalter des SCR-Typs
High-frequency-controlled switch of the SCR-type

(30) Priorité: 04.12.2002 FR 0215322
(43) Date de publication de la demande: 09.06.2004
(73) Titulaire: STMicroelectronics S.A., 92120 Montrouge (FR)
(72) Inventeur: Pezzani, Robert, 37210 Vouvray (FR)
(74) Mandataire: de Beaumont, Michel

(56) Documents cités:
- EP-A- 0 064 349
- US-A- 3 663 950
- US-A- 4 296 296
- US-A- 4 713 723
- US-A- 4 760 432

## Description

La présente invention concerne de façon générale la commande de commutateurs de type SCR. On entend ici par commutateurs de type SCR, des composants tels que des thyristors, de triacs et des commutateurs bidirectionnels commandés de divers types comprenant quatre ou cinq couches semiconductrices alternées. La présente invention s'applique notamment au cas où les commutateurs sont des commutateurs de moyenne puissance destinés à commuter des charges reliées au réseau électrique alternatif (à 50 ou 60 Hz).

De façon générale, dans la commande de commutateurs multiples et/ou de commutateurs alimentés par le réseau alternatif, se pose le problème de l'isolement entre le circuit de commande et le ou les commutateurs à commander, et on prévoit généralement un circuit d'isolement galvanique tel qu'un transformateur ou un optocoupleur qui présente l'inconvénient d'être coûteux et difficilement intégrable.

On a proposé, par exemple dans la demande de brevet PCT WO/0250850 de la demanderesse (B4882), de commander des commutateurs de puissance par des signaux haute fréquence. Dans cette demande de brevet, la haute fréquence est utilisée pour l'avantage qu'elle a de permettre l'utilisation d'un transformateurs de petites dimensions ce qui permet un isolement galvanique à moindre frais mais nécessite quand même un transformateur. Après transformation, cette haute fréquence est appliquée à la gâchette du composant à commuter par l'intermédiaire d'une diode de redressement, c'est-à-dire qu'en fait la commande est réalisée par des signaux en forme d'impulsions continues.

Un procédé selon le préambule de la revendication 1 est connu de EP 0 064 349.

La présente invention propose un nouveau procédé de commande de commutateur de type SCR.

Plus particulièrement, la présente invention propose un tel procédé, et un dispositif adapté, permettant notamment de résoudre de façon particulièrement simple le problème de l'isolement entre le circuit de commande et le commutateur à commander.

Pour atteindre ces objets, la présente invention prévoit un procédé de déclenchement d'un commutateur de type SCR, consistant à appliquer sur la gâchette du commutateur plusieurs périodes d'une tension haute fréquence non redressée, l'énergie d'une alternance HF étant insuffisante pour déclencher le commutateur de type SCR.

Selon un mode de réalisation de la présente invention, la tension HF oscille à une fréquence choisie entre 10 kHz et quelques GHz.

Selon un mode de réalisation de la présente invention, la haute fréquence est appliquée par l'intermédiaire d'une couche isolante formée au-dessus d'une zone sensible du composant.

Selon un mode de réalisation de la présente invention, la haute fréquence est appliquée au-dessus d'une région de gâchette d'un thyristor.

Selon un mode de réalisation de la présente invention, la haute fréquence est appliquée au-dessus d'une région de gâchette d'un triac.

Selon un mode de réalisation de la présente invention, la haute fréquence est appliquée par l'intermédiaire d'une ligne haute fréquence.

Selon un mode de réalisation de la présente invention, la haute fréquence est appliquée par l'intermédiaire d'un enroulement.

La présente invention prévoit aussi un système selon la revendication 8.

Selon un mode de réalisation de la présente invention, l'électrode de commande est disposée au-dessus d'une région de gâchette d'un thyristor.

Selon un mode de réalisation de la présente invention, l'électrode de commande est disposée au-dessus d'une région de gâchette d'un triac.

Selon un mode de réalisation de la présente invention, l'électrode de commande est une ligne haute fréquence.

Selon un mode de réalisation de la présente invention, la haute fréquence est appliquée par l'intermédiaire d'un enroulement.

Selon un avantage de la présente invention, l'application d'un signal HF dans la zone de commande d'un composant de type SCR peut se faire sans qu'une métallisation soit en contact avec la zone semiconductrice sensible, ce qui simplifie la conception et la structure du commutateur et résout tous les problèmes d'isolement et de tension de référence qui se posent classiquement lors de la commande par un même circuit de commande de divers thyristors et/ou triacs, ou autres commutateurs bidirectionnels.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un schéma de principe de commande d'un thyristor ;
la figure 2 représente l'allure du courant s'établissant dans un thyristor pour une tension alternative appliquée à une fréquence de 1 MHz ;
la figure 3 représente l'allure du courant s'établissant dans un thyristor commandé par un signal alternatif à une fréquence de l'ordre de 20 MHz ; et
les figures 4, 5, 6A et 7 représentent divers exemples de mise en oeuvre de la présente invention, la figure 6B étant un schéma équivalent de la réalisation de la figure 6A.

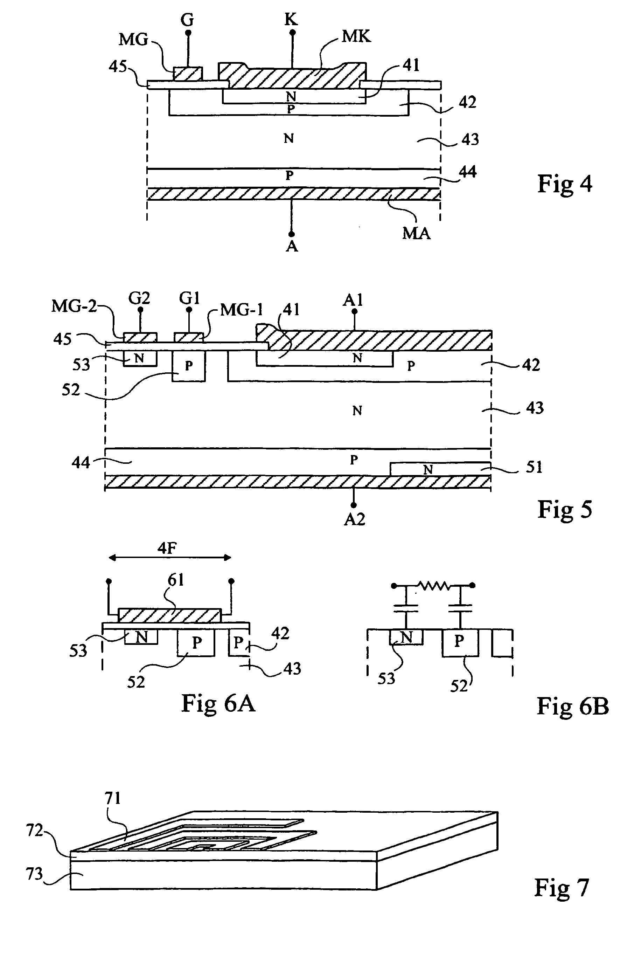

les figures 4, 5, 6A et 7 sont des vues en coupe partielles, schématiques et simplifiées et sont uniquement destinées à simplifier la compréhension de la description ci-après. Notamment, par simplification, certains éléments ont été représentés dans un même plan de coupe alors qu'en fait ils se trouvent dans des plans différents. L'homme de l'art saura réaliser des dispositifs pratiques en utilisant des techniques connues. De plus, comme cela est usuel dans le domaine de la représentation des composants semiconducteurs, les dimensions des diverses couches et régions ne sont pas tracées à l'échelle

L'idée de base de la présente invention est de commander directement un commutateur de type SCR par une tension HF non redressée. On notera que cette approche s'écarte des modes de commande classique d'un commutateur de type SCR selon lesquels on applique une tension ou une impulsion de tension continue sur l'électrode de gâchette, connectée à une zone de gâchette de ce composant. Dans le cas où on applique une impulsion de tension, celle-ci doit être d'amplitude suffisante pour mettre en conduction une jonction et d'intensité suffisante pour faire passer dans cette jonction un courant suffisant. En d'autres termes, l'impulsion doit avoir une énergie minimum donnée.

A priori, quand on applique un signal alternatif à la gâchette d'un thyristor tel que l'énergie de chaque alternance est insuffisante pour mettre en conduction le thyristor et que la durée de chaque alternance est plus courte que le temps d'amorçage du composant, l'effet des alternances positives et négatives s'annule et le signal alternatif n'a aucun effet de déclenchement du commutateur.

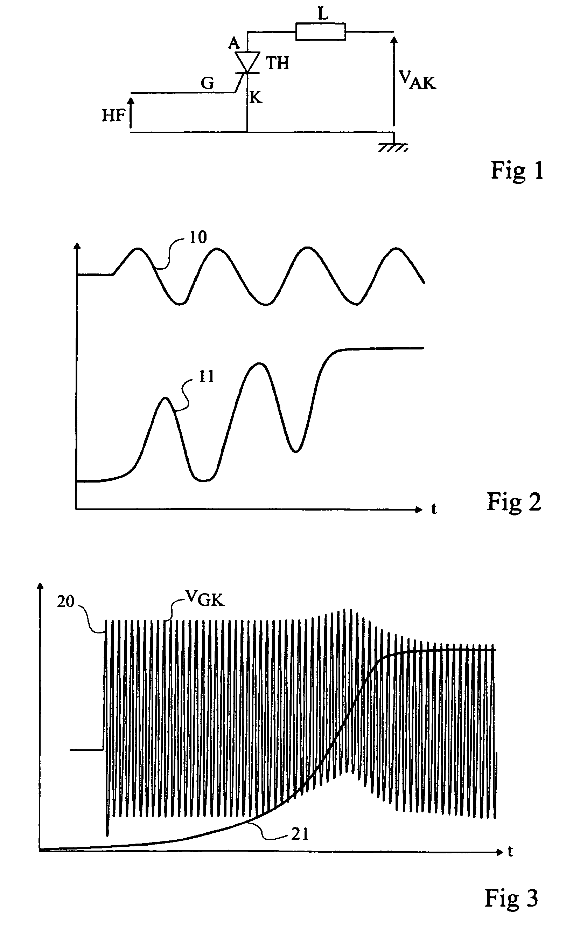

La demanderesse a néanmoins tenté l'expérience dans un schéma du type de celui de la figure 1, dans lequel un signal HF est appliqué entre la gâchette G et la cathode A d'un thyristor. Une tension continue VAK de polarité appropriée est appliquée aux bornes du montage en série d'une charge L et du thyristor TH. On considère que la cathode K du thyristor est reliée à la masse.

En figure 2, on a représenté par une courbe 10 une tension HF à une fréquence d'environ 1 Mégahertz appliquée entre gâchette et cathode, et par une courbe 11 le courant d'anode observé. On note que, après environ trois alternances de la tension alternative haute fréquence, la conduction du thyristor s'établit. Ensuite, comme cela est classique avec un thyristor, on peut interrompre l'alimentation HF et le thyristor reste conducteur.

La figure 3 représente deux courbes similaires pour une tension alternative à une fréquence de l'ordre de 20 MHz. Plus particulièrement, en figure 3, la courbe 20 représente la tension gâchette/cathode et la courbe 21 le courant d'anode. On voit que le courant d'anode croît progressivement avant de s'établir à une valeur suffisante pour que le commutateur reste à l'état passant si la tension haute fréquence est interrompue. La durée d'établissement de la conduction s'étend sur environ 40 à 50 périodes de haute fréquence.

Ainsi, de façon inattendue, quand on applique une tension de commande haute fréquence à la gâchette d'un thyristor, et plus généralement d'un commutateur de type SCR, celui-ci est commuté à l'état passant alors que chaque alternance de la tension alternative a une énergie et/ou une durée insuffisante pour assurer la commutation du composant de type SCR considéré.

Un avantage important de la commande en haute fréquence est que la tension haute fréquence peut être appliquée à la borne de gâchette par l'intermédiaire d'un condensateur de couplage qui présente une très faible impédance pour les hautes fréquences et qui bloque la tension continue ou même la tension alternative à la fréquence du réseau (50 ou 60 hertz), à laquelle sont généralement connectées les bornes de commande d'un commutateur mono ou bidirectionnel. La possibilité d'insérer un tel condensateur de couplage entraîne que les problèmes qui se posent habituellement d'isolement du circuit de commande par rapport au circuit principal d'un commutateur de puissance sont simplement résolus.

La présente invention propose également diverses structures de commutateurs SCR propres à mettre en oeuvre la présente invention.

Un point commun à ces diverses structures est que, comme à l'accoutumée, les électrodes principales du composant commutateur de puissance sont normalement connectées à des zones conductrices appropriées, mais que l'on ne prévoit plus de métallisation de gâchette en contact avec la zone semiconductrice de gâchette. Au lieu de ce contact de gâchette, divers moyens sont prévus pour injecter un signal HF par l'intermédiaire d'une couche isolante vers une zone de déclenchement du commutateur de puissance. En d'autres termes, on réalise un couplage capacitif à travers la couche isolante vers une zone sensible du composant semiconducteur. La couche isolante peut être l'une des couches d'oxyde de silicium couramment utilisées dans les composants semiconducteurs en silicium.

La figure 4 représente un exemple de thyristor à commande HF selon la présente invention. Ce composant de type vertical comprend de façon classique une région de cathode de type N 41, formée dans un caisson de type P 42, lui-même formé dans une couche faiblement dopée de type N 43, une région d'anode de type P 44 étant présente du côté de la face arrière du composant. La région de type N 41 est en contact avec une métallisation de cathode MK et est reliée à une borne de cathode K. La face arrière du composant est revêtue d'une métallisation d'anode MA et est reliée à une borne d'anode A. On rappelle que, de façon classique, une borne de gâchette est formée par une métallisation en contact avec une portion de la couche 42. Selon la présente invention, la région 42 est uniformément revêtue d'une couche isolante 45 au-dessus de laquelle est formée une métallisation MG à laquelle on prévoit de fournir un signal haute fréquence de déclenchement. On soulignera à nouveau que la métallisation MG est complètement isolée par rapport au circuit principal du thyristor. La fréquence HF peut être appliquée entre la borne G et l'une ou l'autre des bornes A et K, qui, étant à des potentiels fixés, sont considérées comme des masses du point de vue des hautes fréquences.

La figure 5 représente une application de la présente invention à la commande d'un triac. Ce triac comprend les mêmes couches 41 à 44 que celles décrites précédemment pour le thyristor de la figure 4. Dans la couche 44 de type P de face arrière est en outre formée une région 51 de type N en contact avec la métallisation de face arrière et, de façon classique, il est formé une région 52 de type P du côté de la face avant dans la région de type N 43, correspondant à une région de gâchette. De préférence, on prévoit également une région de type N plus fortement dopée 53 au voisinage de la région 52. Des métallisations MG1 et MG2 sont respectivement formées au-dessus des régions de type P 52 et de type N 53. On pourra par exemple appliquer un signal haute fréquence entre les bornes G1 et G2 reliées aux métallisations MG1 et MG2 et l'on constate que ceci déclenche le triac de la même façon que le thyristor était déclenché précédemment. On notera que la borne G2 est optionnelle et que l'on pourra appliquer un signal HF de commande seulement sur la borne G1. On constate alors également un déclenchement du triac.

La figure 6A représente une variante de réalisation de la structure représentée en figure 5. Au lieu de prévoir deux métallisations MG1 et MG2 entre lesquelles on applique un signal haute fréquence, on prévoit au dessus des régions 52 et 53 une ligne haute fréquence 61 entre les bornes de laquelle on applique une tension haute fréquence HF. A nouveau, par couplage capacitif, comme cela est illustré en figure 6B, il se met à circuler un courant dans les couches sous-jacentes et l'on constate que ceci conduit à une mise en conduction du composant principal.

Selon une autre variante de la présente invention, comme cela est illustré schématiquement en figure 7, la haute fréquence peut être appliquée à une zone sensible du commutateur par l'intermédiaire d'un enroulement 71 formé sur une couche isolante 72 revêtant le substrat 73 dans lequel est formé le composant de puissance, de la façon illustrée en figure 4 ou 5. Diverses applications d'une telle injection de HF par une bobine peuvent être utilisées. On peut former un enroulement secondaire dans le semiconducteur, par exemple à partir d'une couche diffusée ou d'une zone remplie de matériau conducteur tel que du silicium polycristallin formé dans des rainures isolées ménagées dans une portion du substrat semiconducteur, la HF étant alors présente aux extrémités de l'enroulement secondaire. On peut aussi prévoir que l'enroulement 71 produit un champ magnétique qui crée dans le matériau conducteur des courants de Foucault qui entraînent la mise en conduction de jonctions sensibles de la façon indiquée précédemment. Dans une telle application, les fréquences peuvent être très élevées, de l'ordre de plusieurs mégahertz à plusieurs gigahertz.

On comprendra que la présente invention est susceptible de nombreuses variantes et modifications, la base de la présente invention résidant dans une commande par un signal haute fréquence d'un composant semiconducteur, par injection de haute fréquence dans une zone sensible de ce composant semiconducteur. Cette zone sensible pourra être distincte des zones de gâchette classiques de composants de type SCR ; il suffit qu'il se produise la mise en conduction d'une jonction qui génère des charges au voisinage de la jonction bloquante d'un composant de type SCR convenablement polarisé. La plage de haute fréquence sera adaptée au contexte de l'application. On peut par exemple envisager selon l'application des hautes fréquences dans une plage de 10 kHz à plusieurs GHz. Comme on l'a indiqué précédemment, chacune des alternances haute fréquence n'a pas besoin d'être très énergétique puisque, comme on l'a montré en relation avec les figures 2 et 3, il se produit un phénomène d'accumulation qui entraîne un déclenchement progressif du composant semiconducteur commandé.

De plus, bien que l'invention ait été décrite en relation avec des exemples simplifiés de thyristors et de triacs particuliers, elle s'applique à tout composant de type SCR et en particulier à tout type de composant bidirectionnel.

## Revendications

1. Procédé de déclenchement d'un commutateur (TH) de type SCR, consistant à appliquer sur la gâchette (G) du commutateur (TH) plusieurs périodes d'une tension haute fréquence (HF) non redressée, **caractérisé en ce que** l'énergie de chacune des alternances HF est insuffisante pour déclencher le commutateur (TH) de type SCR.

2. Procédé de commande selon la revendication 1, dans lequel la tension HF oscille à une fréquence choisie entre 10 kHz et quelques GHz.

3. Procédé selon la revendication 1, dans lequel la haute fréquence est appliquée par l'intermédiaire d'une couche isolante (45) formée au-dessus d'une zone sensible (42) du commutateur (TH).

4. Procédé selon la revendication 3, dans lequel la haute fréquence (HF) est appliquée au-dessus d'une région de gâchette d'un thyristor.

5. Procédé selon la revendication 3, dans lequel la haute fréquence est appliquée au-dessus d'une région de gâchette (52) d'un triac.

6. Procédé selon la revendication 3, dans lequel la haute fréquence est appliquée par l'intermédiaire d'une ligne haute fréquence (61).

7. Procédé selon la revendication 3, dans lequel la haute fréquence est appliquée par l'intermédiaire d'un enroulement (71).

8. Système comprenant un composant commutateur (TH) de type SCR et un dispositif de déclenchement du composant (TH), le composant (TH) comprenant deux électrodes (A, K) principales et au moins une électrode (G) de commande formée sur une couche isolante (45) et disposée au-dessus d'une région de déclenchement du composant (TH), ce dispositif de commande étant adapté à appliquer à ladite électrode (G) de commande un signal HF non redressé, **caractérisé en ce que** l'énergie de chacune des alternances HF est insuffisante pour déclencher le commutateur (TH) de type SCR.

9. Système selon la revendication 8, dans lequel l'électrode de commande est disposée au-dessus d'une région de gâchette (42) d'un thyristor.

10. Système selon la revendication 8, dans lequel l'électrode de commande est disposée au-dessus d'une région de gâchette (52) d'un triac.

11. Système selon la revendication 8, dans lequel l'électrode de commande est une ligne haute fréquence (61).

12. Système selon la revendication 8, dans lequel la haute fréquence est appliquée par l'intermédiaire d'un enroulement (71).

## Claims

1. A method for triggering an SCR-type switch (TH), consisting of applying to the switch gate (G) several periods of an unrectified high-frequency voltage (HF), **characterized in that** the power of each HF halfwave is insufficient to start the SCR-type switch (TH).

2. The control method of claim 1, wherein the HF voltage oscillates at a selected frequency between 10 kHz and a few GHz.

3. The method of claim 1, wherein the high frequency is applied via an insulating layer (45) formed above a sensitive area (42) of the switch (TH).

4. The method of claim 3, wherein the high frequency (HF) is applied above a gate region of a thyristor.

5. The method of claim 3, wherein the high frequency is applied above a gate region (52) of a triac.

6. The method of claim 3, wherein the high frequency is applied via a high-frequency line (61).

7. The method of claim 3, wherein the high frequency is applied via a winding (71).

8. A system comprising an SCR-type switch component (TH) and a triggering device of the switch component, the component (TH) comprising two main electrodes (A, K) and at least one control electrode (G) formed on an insulating layer (45) and arranged above a starting region of the component (TH), this triggering device being adapted to apply to said control electrode (G) an unrectified HF power supply, **characterized in that** the power of each HF halfwave is insufficient to start the SCR-type switch (TH).

9. The system of claim 8, wherein the control electrode is arranged above a gate region (42) of a thyristor.

10. The system of claim 8, wherein the control electrode is arranged above a gate region (52) of a triac.

11. The system of claim 8, wherein the control electrode is a high-frequency line (61).

12. The system of claim 8, wherein the high frequency is applied via a winding (71).

## Patentansprüche

1. Verfahren zum Auslösen eines SCR-Schalters (TH), das darin besteht, an das Gate (G) des Schalters (TH) mehrere Perioden einer nicht gleichgerichteten Hochfrequenz-Spannung (HF) anzulegen, **dadurch gekennzeichnet, dass** die Energie jeder der HF-Halbwellen nicht ausreichend ist, um den SCR-Schalter (TH) auszulösen.

2. Verfahren nach Anspruch 1, wobei die HF-Spannung bei einer ausgewählten Frequenz zwischen 10 kHz und einigen GHz oszilliert.

3. Verfahren nach Anspruch 1, wobei die Hochfrequenz über eine Isolationsschicht (45), die über einer Fühlerschicht (42) des Schalters (TH) ausgebildet ist.

4. Verfahren nach Anspruch 3, wobei die Hochfrequenz (HF) über einem Gatebereich eines Thyristors angelegt wird.

5. Verfahren nach Anspruch 3, wobei die Hochfrequenz über einem Gatebereich (52) eines Triac angelegt wird.

6. Verfahren nach Anspruch 3, wobei die Hochfrequenz über eine Hachfrequenzleitung (61) angelegt wird.

7. Verfahren nach Anspruch 3, wobei die Hochfrequenz über eine Spule (71) angelegt wird.

8. System mit einem SCR-Schalterbauteil (TH) und einer Auslöseeinrichtung des Schalterbauteils (TH), wobei das Schalterbauteil (TH) zwei Hauptelektroden (A, K) und wenigstens eine Steuerelektrode (G) aufweist, die auf einer Isolationsschicht (45) ausgebildet und über einem Auslösebereich des Bauteils (TH) angeordnet ist, wobei die Auslösevorrichtung dazu geeignet ist, an die Steuerelektrode (G) ein nicht gleichgerichtetes HF-Signal anzulegen, **dadurch gekennzeichnet, dass** die Energie jeder HF-Halbwelle unzureichend ist, um den SCR-Schalter (TH) auszulösen.

9. System nach Anspruch 8, wobei die Steuerelektrode über einem Gatebereich (42) eines Thyristors angeordnet ist.

10. System nach Anspruch 8, wobei die Steuerelektrode über einem Gatebereich (52) eines Triac angeordnet ist.

11. System nach Anspruch 8, wobei die Steuerelektrode über einer Hochfrequenz-Leitung (61) angeordnet ist.

12. System nach Anspruch 8, wobei die Hochfrequenz über eine Spule (71) angelegt wird.
